# EUROPEAN PATENT APPLICATION

(11) **EP 4 636 812 A1**
(43) Date of publication of application: **22.10.2025**
(21) Application number: 24878356.5
(22) Date of filing: 22.02.2024
(51) Int. Cl.: H01L 21/50, H01L 21/56, H01L 21/60, H01L 25/16, H01L 23/498, G02B 6/42

(54) **GRATING-BASED SEMICONDUCTOR PHOTOELECTRIC PACKAGING STRUCTURE AND PREPARATION METHOD THEREFOR**

(30) Priority: 20.10.2023 CN 202311360933
(71) Applicant: SJ Semiconductor (Jiangyin) Corporation, Jiangyin, Jiangsu 214437 (CN)
(72) Inventor: CHEN, Yenheng, Wuxi, Jiangsu 214437 (CN); LIN, Chengchung, Wuxi, Jiangsu 214437 (CN)
(74) Representative: Canzler & Bergmeier Patentanwälte Partnerschaft mbB
(86) International application number: PCT/CN2024/078024
(87) International publication number: WO 2025/081699

(57) **Abstract**

Provided are a grating-based semiconductor photoelectric packaging structure and a preparation method therefor. A composite function chip is prepared, such that one side of the composite function chip is provided with an electrical metal wiring layer to combine with a metal column and a rewiring layer for electrical transmission, and the other side of the composite function chip is provided with an inclined reflection grating. An optical waveguide wiring layer and an optical chip are combined for optical transmission, so as to implement combined packaging of the optical chip and the electrical chip, to achieve photoelectric integration, reduce the packaging size, decrease the power consumption, and improve the reliability. **The** present invention is suitable for high-density integrated packaging, and can achieve good photoelectric signal transmission.

## Description

### FIELD OF TECHNOLOGY

The present disclosure belongs to the field of semiconductor manufacturing technology, and in particular, it relates to a grating-based semiconductor optoelectronic packaging structure and a preparation method therefor.

### BACKGROUND

With the continuous development of big data, artificial intelligence, telemedicine, the Internet of Things, e-commerce, and 5G communications, the global data traffic has experienced explosive growth. Lower cost, higher reliability, faster speed, and higher-density circuits have become the pursued goals of integrated circuit packaging.

To meet the demands of the internet traffic, bandwidth of data center nodes needs to reach 10 Tb/s. To mitigate the trend of increasing energy consumption in data centers, it is imperative to reduce the power consumption of systems and devices. Driven by ultra-high data capacity, traditional CMOS chip process technology is gradually approaching its physical limits (10 nm scale). However, the advantages of optical signals-such as low attenuation, low energy consumption, high bandwidth, and compatibility with CMOS process-the industry in large believes that silicon photonic chips, which integrate standard microelectronics and optoelectronics technologies, can reduce chip size, lower cost and power consumption, and improve reliability, thereby are expected to become a high-speed information engine "Beyond Moore". Therefore, the introduction of silicon photonic technology is essential. Since the introduction of silicon photonic technology increases input/output (I/O) bandwidth while minimizing energy consumption, the packaging of photonic integrated circuits (PICs) and electronic integrated circuits (EICs) becomes critical, as these factors directly affect I/O bandwidth and energy consumption.

Most existing optoelectronic integrated semiconductor packaging structures directly bond photonic integrated chips and electronic integrated chips onto a substrate, establishing electrical connections with the substrate through wire bonds or flip-chip methods. However, silicon photonic process nodes lag far behind those of electrical chips. For example, the current silicon photonic process nodes for monolithic integration development are 45 nm and 32 nm, which are significantly behind the sub-10 nm process nodes of CMOS chips. As a result, existing optoelectronic integrated semiconductor packaging structures have been struggling to meet the demands of the high-density integrated packaging.

Therefore, it is necessary to provide a grating-based semiconductor optoelectronic packaging structure and a preparation method therefor.

### SUMMARY

The present disclosure provides a grating-based semiconductor optoelectronic packaging structure and a preparation method therefor, which can meet the demands of high-density integrated packaging of an electrical chip and an optical chip.

The preparation method for the grating-based semiconductor optoelectronic packaging structure includes the following steps.

Providing a wafer-level electrical chip including a circuit region at a bottom portion and a substrate region at a top portion.

Forming tilted grooves in the substrate region of the wafer-level electrical chip by patterning, wherein the tilted grooves constitute a tilted reflective grating.

Forming metal interconnects on the surface of the circuit region, and the metal interconnects are electrically connected to the circuit region.

Dicing the wafer-level electrical chip to form a composite functional chip.

Providing a support substrate having a debonding layer on its surface, and forming a redistribution layer on the debonding layer.

Forming metal pillars on the redistribution layer and bonding the composite functional chip to the redistribution layer via the metal interconnects, and the first ends of the metal pillars and the metal interconnects are electrically connected to the redistribution layer.

Forming an encapsulation layer covering the metal pillars, the composite functional chip, and the redistribution layer while exposing second ends of the metal pillars and the tilted reflective grating.

Forming an optical waveguide routing layer on the encapsulation layer. The optical waveguide routing layer is arranged to align with one end of the tilted reflective grating.

Providing an optical chip having a photosensitive region, and bonding the optical chip onto the encapsulation layer. The optical chip is electrically connected to the second ends of the metal pillars, and the photosensitive region is aligned to be at a preset position with the tilted reflective grating to transmit optical output.

Optionally, the tilted reflective grating has a tilt angle in a range of 30°to 60° or 120° to 150°.

Optionally, the preparation method further includes forming a first optical protection layer covering the tilted grooves, and/or forming a second optical protection layer covering the optical waveguide routing layer, and the second optical protection layer exposes portions of the optical waveguide routing layer to form optical waveguide ports. The first optical protection layer and the second optical protection layer are formed by a semiconductor exposure and development method and include a metal-based optical protection layer or an organic-inorganic composite optical protection layer.

Optionally, the optical waveguide routing layer is formed by a semiconductor exposure and development method and includes one of an organic polymer waveguide routing layer, a silicon-based waveguide routing layer, a lithium niobate waveguide routing layer, and a lithium borate waveguide routing layer.

Optionally, the preparation method further includes forming a filling layer to fill the tilted grooves. The filling layer includes a high-molecular-weight transparent filling layer.

The present disclosure also provides a grating-based semiconductor optoelectronic packaging structure, including:
a redistribution layer;
a composite functional chip, disposed on the redistribution layer, including a circuit region at a bottom portion and a substrate region at a top portion, and the substrate region includes tilted grooves constituting a tilted reflective grating, and a surface of the circuit region includes metal interconnects electrically connected to the circuit region and the redistribution layer;
metal pillars, disposed on the redistribution layer, and the first ends of the metal pillars are electrically connected to the redistribution layer;
an encapsulation layer, covering the metal pillars, the composite functional chip, and the redistribution layer while exposing second ends of the metal pillars and the tilted reflective grating;
an optical waveguide routing layer, disposed on the encapsulation layer and aligned with the tilted reflective grating; and
an optical chip, bonded onto the encapsulation layer, including a photosensitive region and electrically connected to the second ends of the metal pillars, and the photosensitive region is optically aligned with the tilted reflective grating.

Optionally, the tilted reflective grating has a tilt angle made in a range of 30° to 60° or 120° to 150°.

Optionally, the structure further includes a first optical protection layer covering the tilted grooves, and/or a second optical protection layer covering the optical waveguide routing layer, and the second optical protection layer exposes portions of the optical waveguide routing layer to form optical waveguide ports. The first optical protection layer and the second optical protection layer include a metal-based optical protection layer or an organic-inorganic composite optical protection layer.

Optionally, the optical waveguide routing layer includes one of an organic polymer waveguide routing layer, a silicon-based waveguide routing layer, a lithium niobate waveguide routing layer, and a lithium borate waveguide routing layer.

Optionally, the structure further includes a filling layer to fill the tilted grooves. The filling layer includes a high-molecular-weight transparent filling layer.

The present disclosure provides a grating-based semiconductor optoelectronic packaging structure and a preparation method therefor. A composite functional chip is prepared. The first side of the composite functional chip is provided with an electrical metal wiring layer to combine with metal pillars and a redistribution layer (RDL) for electrical transmission. The second side of the composite functional chip is provided with a tilted reflective grating to combine with an optical waveguide routing layer and an optical chip for optical transmission. The composite functional chip enables the integrated packaging of optical and electrical chips, achieving optoelectronic integration, reducing packaging size, lowering power consumption, improving reliability, and being suitable for high-density integrated packaging with excellent optoelectronic signal transmission.

### BRIEF DESCRIPTION OF THE DRAWINGS

FIG. 1 shows a flow chart of a preparation method for a grating-based semiconductor optoelectronic packaging structure according to an embodiment of the present disclosure.
FIG. 2 shows a schematic structural diagram of a wafer-level electrical chip according to an embodiment of the present disclosure.
FIG. 3a shows a schematic structural diagram of the wafer-level electrical chip after forming a tilted reflective grating on it according to an embodiment of the present disclosure.
FIG. 3b shows another schematic structural diagram of the wafer-level electrical chip after forming a tilted reflective grating on it according to an embodiment of the present disclosure.
FIG. 4 shows a schematic structural diagram of the wafer-level electrical chip after forming a filling layer in the tilted reflective grating according to an embodiment of the present disclosure.
FIG. 5 shows a schematic structural diagram after forming first metal interconnects on the wafer-level electrical chip and dicing the chip to form a composite functional chip according to an embodiment of the present disclosure.
FIG. 6 shows a schematic structural diagram of a support substrate with a debonding layer according to an embodiment of the present disclosure.
FIG. 7 shows a schematic diagram of a packaging structure after forming a redistribution layer (RDL), metal pillars, and bonding the composite functional chip to the redistribution layer via the metal interconnects according to an embodiment of the present disclosure.
FIG. 8 shows a schematic diagram of the packaging structure after forming an encapsulation layer on the support substrate, according to an embodiment of the present disclosure.
FIG. 9 shows a schematic diagram of the packaging structure after forming an optical waveguide routing layer on the support substrate, according to an embodiment of the present disclosure.
FIG. 10 shows a schematic diagram of the packaging structure after bonding the optical chip onto the encapsulation layer and forming a second metal interconnect on the support substrate, according to an embodiment of the present disclosure.
FIG. 11 shows an enlarged schematic structural diagram of region A in FIG. 10, according to an embodiment of the present disclosure.

### Reference Numerals

100, Composite Functional Chip; 101, Wafer-Level Electrical Chip; 101a, Circuit Region; 101b, Substrate Region; 102, Bond Pad; 103, Tilted Reflective Grating; 1031, Tilted Groove; 104, Filling Layer; 105, First Metal Interconnect; 200, Support Substrate; 300, Debonding Layer; 400, Redistribution Layer (RDL); 500, Metal Pillar; 600, Encapsulation Layer; 700, Optical Waveguide Routing Layer; 800, Optical Chip; 801, Photosensitive Region; 900, Second Metal Interconnect.

### DETAILED DESCRIPTION

The following describes the implementation of the present disclosure through specific embodiments. Those skilled in the art can readily understand other advantages and effects of the present disclosure from the content disclosed in this specification. The present disclosure may also be implemented or applied through other specific embodiments, and various details in this specification may be modified or changed based on different perspectives and applications.

When detailing the embodiments of the present disclosure, for ease of explanation, cross-sectional views illustrating the device structure may not be drawn to scale and may include partial enlargements. Furthermore, the schematic diagrams are merely illustrative and should not be construed as limiting the scope of protection of the present disclosure. Additionally, actual fabrication should account for three-dimensional spatial dimensions, including length, width, and depth.

For convenience of description, spatial relational terms such as "below," "under," "lower," "above," "on", "upper," etc., may be used herein to describe the relationship of one element or feature to another element or feature as illustrated in the accompanying drawings. It should be understood that these spatial relational terms are intended to encompass orientations of the device in use or operation beyond those depicted in the drawings. This may include embodiments where the first and second features are in direct contact, as well as embodiments where additional features are formed between the first and second features such that the first and second features may not be in direct contact. Moreover, when a layer is referred to as being "between" two layers, it may be the only layer between the two layers, or one or more intervening layers may also be present.

It should be noted that the diagrams provided in this embodiment are merely intended to illustrate the basic concept of the present disclosure in a schematic manner. Thus, the diagrams only show components relevant to the present disclosure and are not drawn according to the actual number, shape, or size of components during implementation. During actual implementation, the form, quantity, and proportion of components may vary arbitrarily, and the layout of components may also be more complex.

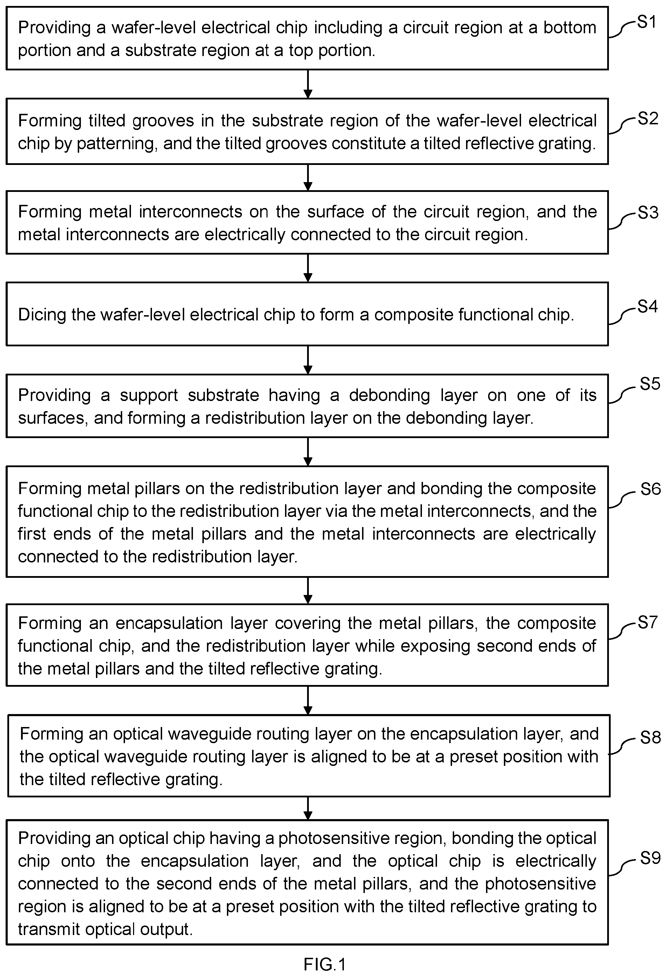

As shown in FIG. 1, the present embodiment provides a grating-based semiconductor optoelectronic packaging structure and a preparation method therefor. A composite functional chip is prepared. The first side of the composite functional chip is provided with an electrical metal wiring layer to combine with metal pillars and a redistribution layer (RDL) for electrical transmission. The second side of the composite functional chip is provided with a tilted reflective grating to combine with an optical waveguide routing layer and an optical chip for optical transmission. The composite functional chip enables the integrated packaging of optical and electrical chips, achieving optoelectronic integration, reducing packaging size, lowering power consumption, improving reliability, and being suitable for high-density integrated packaging with excellent optoelectronic signal transmission.

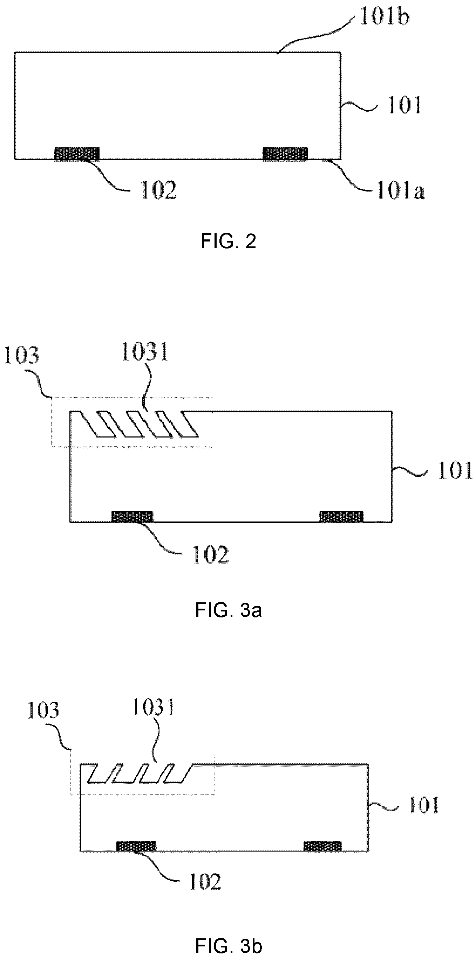

The following paragraphs further describe a preparation method of the semiconductor optoelectronic packaging structure with reference to FIGS. 2 to 11.

First, referring to FIGS. 1 and 2, step S1 is performed to provide a wafer-level electrical chip 101. The wafer-level electrical chip 101 includes a circuit region 101a at the bottom portion and a substrate region 101b at the top portion.

Specifically, the wafer-level electrical chip 101 may have sizes such as 4 inches, 6 inches, 8 inches, or 12 inches. The sizes of the wafer-level electrical chip 101 are not limited by the figures here and may be selected as needed.

The circuit region 101a is disposed at the bottom of the wafer-level electrical chip 101 for electrical signal transmission, while the substrate region 101b of the wafer-level electrical chip 101 provides space for subsequent fabrication of a tilted reflective grating 103. The material of the substrate region 101b in the wafer-level electrical chip 101 may include, but is not limited to, silicon, glass, or silicon oxide. The specific type of wafer-level electrical chip 101 may be selected as needed.

FIG. 2 only illustrates having bond pads 102 in the circuit region 101a for electrical connections, while the arrangement of metal wiring layers in the circuit region 101a is not shown in the figures.

Next, referring to FIGS. 1, 3a, and 3b, step S2 is performed to pattern the wafer-level electrical chip 101 and form tilted grooves 1031 in the substrate region 101b to constitute a tilted reflective grating 103.

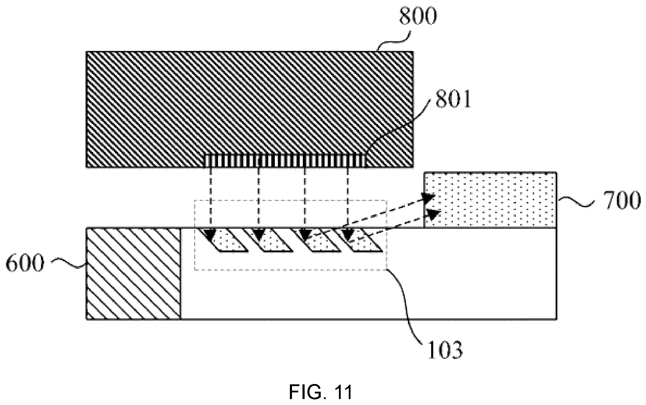

Specifically, a semiconductor lithographic exposure and development method may be used to pattern non-circuit areas at the top of the wafer-level electrical chip 101. For example, a photomask with a tilted angle may be employed to form tilted patterns in photoresist, followed by dry or wet etching to create the tilted grooves 1031. These tilted grooves 1031 include multiple parallel, uniformly wide, equally spaced oblique trenches, thereby constituting a planar reflective grating 103 with a specific tilt angle. The tilted reflective grating 103 serves as an optical transmission medium to facilitate light transmission between an optical chip 800 and an optical waveguide routing layer 700, as shown in FIG. 11.

As an example, the tilt angle of the tilted reflective grating 103 may range from 30° to 60° or 120° to 150°.

Specifically, FIG. 3a illustrates the tilted reflective grating 103 with a tilt angle of 120° to 150°, such as 120°, 130°, or 150°. Alternatively, as shown in FIG. 3b, the tilt angle may range from 30° to 60°, such as 30°, 40°, or 60°. Adjusting the tilt angle of the tilted reflective grating 103 controls the light reflection angle, facilitating optical transmission between the optical chip 800 and the optical waveguide routing layer 700. The selection of the tilt angle, the spacing between tilted grooves 1031, and the opening morphology of the tilted grooves 1031 may be adjusted as needed.

As an example, after forming the tilted grooves 1031, the preparation method may further include a step of forming a first optical protection layer (not shown in the figures) covering the tilted grooves 1031 to reduce optical loss. The first optical protection layer may be formed using a semiconductor exposure and development method and may include a metal-based optical protection layer or an organic-inorganic composite optical protection layer.

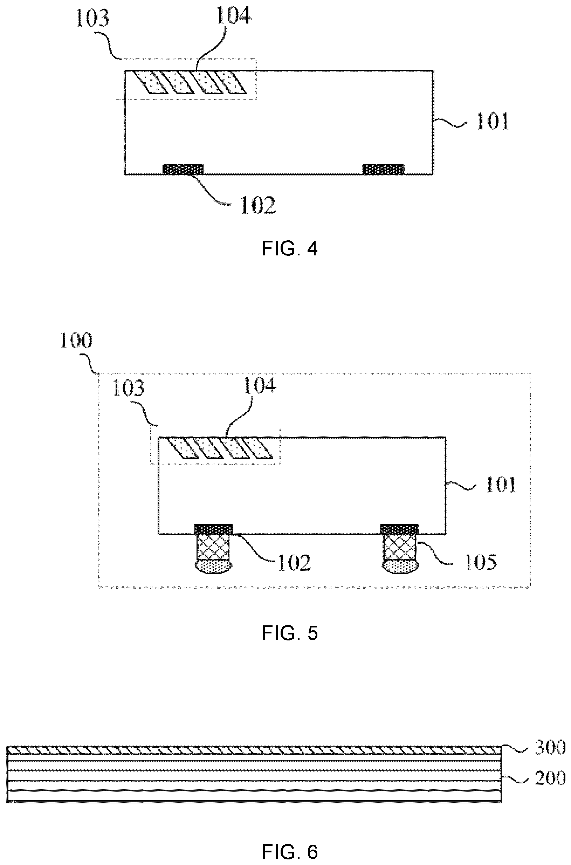

As an example, referring to FIG. 4, the preparation method may further include a step of forming a filling layer 104 to fill the tilted grooves 1031. The filling layer 104 may be formed using coating methods and may include a high-molecular-weight transparent material, such as transparent polyimide (PI) or polybenzoxazole (PBO). The filling layer 104 fills the tilted grooves 1031, facilitating subsequent processes.

Next, referring to FIGS. 1 and 5, step S3 is performed to form the first metal interconnects 105 on the surface of the circuit region 101a, with the first metal interconnects 105 electrically connected to the circuit region 101a.

Specifically, in this embodiment, the first metal interconnects 105 adopt a composite structure of metal pillars or metal bumps, electrically connected to the bond pads 102 for subsequent electrical interfacing. However, the type of the first metal interconnect 105 is not limited and may also include isolated metal bumps or pillars, selected as needed.

Next, referring to FIGS. 1 and 5, step S4 is performed to dice the structure and form a composite functional chip 100.

As an example, dicing methods may include mechanical cutting or laser cutting, selected as needed.

Next, referring to FIGS. 1, 5, 6, and 7, step S5 is performed to provide a support substrate 200 with a debonding layer 300 on its surface and form a redistribution layer (RDL) 400 on the debonding layer 300.

Specifically, the debonding layer 300 may include, but is not limited to, adhesive tape or polymer layers. For example, the debonding layer 300 may be a photothermal conversion layer, allowing subsequent laser heating to remove the support substrate 200 for improved process flexibility.

The redistribution layer 400 includes an insulating dielectric layer and a metal wiring layer for electrical connections. The specific material, structure, and fabrication method of the redistribution layer 400 are not limited by the figures here and may be selected as needed.

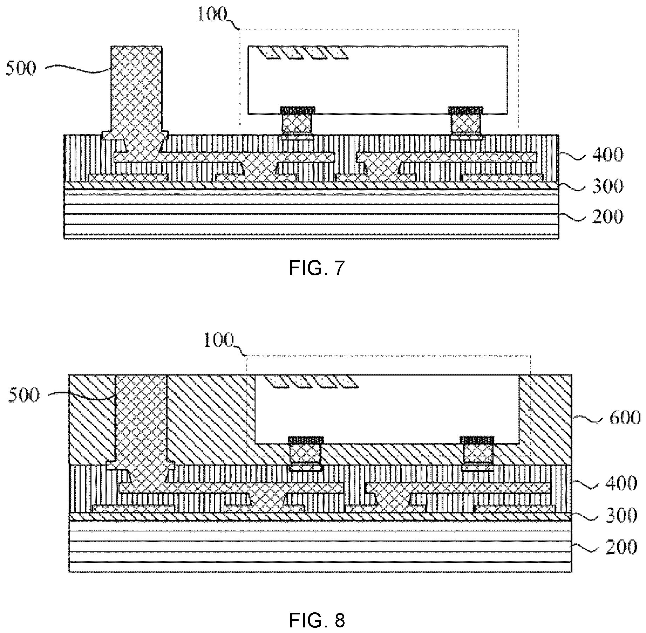

Next, referring to FIGS. 1 and 7, step S6 is performed to form metal pillars 500 on the redistribution layer 400 and bond the composite functional chip 100 to the redistribution layer 400 via the first metal interconnects 105. The first ends of the metal pillars 500 and the first metal interconnects 105 are both electrically connected to the redistribution layer 400.

Specifically, the sequence of forming the metal pillars 500 and bonding the composite functional chip 100 is not limited and may be adjusted as needed. The metal pillars 500 may be copper pillars. The materials and the fabrication method of the metal pillars 500 are not limited by the figures here.

Finally, referring to FIGS. 1 and 8, step S7 is performed to form an encapsulation layer 600 covering the metal pillars 500, the composite functional chip 100, and the redistribution layer 400, while exposing the second ends of the metal pillars 500 and the tilted reflective grating 103.

Specifically, the material of the encapsulation layer 600 may employ commonly used epoxy resin or similar materials. Methods for forming the encapsulation layer 600 may include molding, vacuum lamination, and spin coating, among others. The material and formation method of the encapsulation layer 600 are not limited by the figures here.

After forming the encapsulation layer 600, a grinding process may be employed to expose the second ends of the metal pillars 500 and the tilted reflective grating 103. The grinding process can reduce the thickness of the encapsulation layer 600 and achieve a flat top surface. The grinding process may include, but is not limited to, chemical mechanical polishing (CMP), physical grinding, or a combination of physical grinding and CMP.

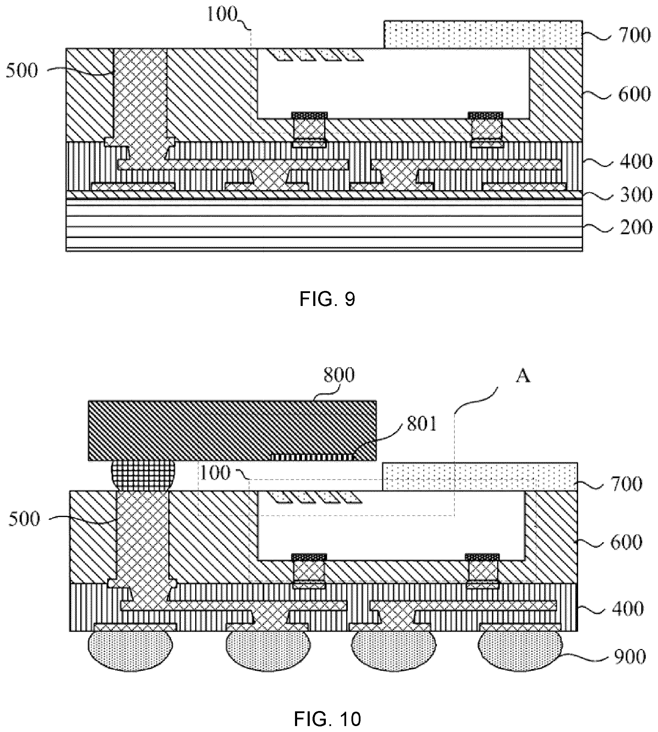

Next, referring to FIGS. 1 and 9, step S8 is performed to form an optical waveguide routing layer 700 on the encapsulation layer 600. The optical waveguide routing layer 700 is arranged to be aligned with the tilted reflective grating 103 to facilitate optical transmission.

As an example, the optical waveguide routing layer 700 may be formed using a semiconductor lithographic exposure and development method. The optical waveguide routing layer 700 may include one of an organic polymer-based waveguide routing layer, a silicon-based waveguide routing layer, a lithium niobate waveguide routing layer, and a lithium borate waveguide routing layer. For example, materials for the organic polymer-based waveguide routing layer may include polymethyl methacrylate (PMMA), polystyrene (PS), polycarbonate (PC), epoxy resin, or fluorinated polyimide. The material, distribution, and fabrication method of the optical waveguide routing layer 700 are not limited by the figures here.

Additionally, the preparation method may include a step of forming a second optical protection layer (not shown in figures) covering the optical waveguide routing layer 700. The second optical protection layer exposes portions of the optical waveguide routing layer 700 to form optical waveguide ports (not shown in figures), enabling light transmission through the optical waveguide ports. The morphology and dimensions of the optical waveguide ports are not limited by the figures here.

The second optical protection layer may be formed via a semiconductor exposure and development method and may include a metal-based optical protection layer or an organic-inorganic composite optical protection layer to minimize optical loss. The specific choice of the second optical protection layer is not limited.

Next, referring to FIGS. 1, 5, and 10, step S9 is performed to provide an optical chip 800 with a photosensitive region 801. The optical chip 800 is bonded onto the encapsulation layer 600, and electrically connected to the second ends of the metal pillars 500. The photosensitive region 801 is aligned to receive light from the tilted reflective grating 103 for optical transmission (as indicated by the dashed arrow lines in FIG. 11).

The quantity and arrangement of the optical chip 800, composite functional chip 100, and optical waveguide routing layer 700 may be adjusted as needed and are not limited by the figures here.

Furthermore, as shown in FIG. 10, the preparation method may include a step of removing the debonding layer 300 and the support substrate 200, to expose the redistribution layer 400. Second metal interconnects 900 may be formed on the exposed redistribution layer 400 and electrically connected to the redistribution layer 400 for subsequent electrical connections. The second metal interconnects 900 may be, and not limited to, metal bumps.

When the debonding layer 300 is a photothermal conversion layer, laser heating may be used to facilitate the removal of the support substrate 200.

**It** should be noted that steps S5 to S9 may be performed at the wafer level to improve production efficiency, followed by a dicing step to obtain individual structures as shown in FIG. 10. Alternatively, steps S5 to S9 may directly produce individual structures, depending on requirements.

Referring to FIGS. 2 to 11, this embodiment also provides a grating-based semiconductor optoelectronic packaging structure, which may be fabricated using the preparation method of the present disclosure. Details regarding materials and preparation methods can be referenced from the above description. Alternatively, other preparation methods may also be employed for the grating-based semiconductor optoelectronic packaging structure as needed.

Specifically, in the present embodiment, the grating-based semiconductor optoelectronic packaging structure includes a redistribution layer (RDL) 400, a composite functional chip 100, metal pillars 500, an encapsulation layer 600, an optical waveguide routing layer 700, and an optical chip 800.

The composite functional chip 100 is disposed on the redistribution layer 400 and includes a circuit region 101a at its bottom and a substrate region 101b at its top. In the substrate region 101b, multiple tilted grooves 1031 form a tilted reflective grating 103. On the surface of the circuit region 101a, multiple first metal interconnects 105 (such as metal pillars, metal bumps, or a combination thereof) are electrically connected to the circuit region 101a and the redistribution layer 400, respectively. The metal pillars 500 are disposed on the redistribution layer 400, with their first ends electrically connected to the redistribution layer 400. The encapsulation layer 600 covers the metal pillars 500, composite functional chip 100, and redistribution layer 400 while exposing the second ends of the metal pillars 500 and the tilted reflective grating 103. The optical waveguide routing layer 700 is formed on the encapsulation layer 600 and aligned with the tilted reflective grating 103 for optical transmission. The optical chip 800 is bonded to the encapsulation layer 600, featuring a photosensitive region 801 electrically connected to the second ends of the metal pillars 500 and optically aligned with the tilted reflective grating 103 for light transmission.

Specifically, the quantity and arrangement of the optical chip 800, composite functional chip 100, and the optical waveguide routing layer 700 in the grating-based semiconductor optoelectronic packaging structure may be configured as needed and are not limited by the figures here.

As an example, the tilted reflective grating 103 may have a tilt angle ranging from 30° to 60° or 120° to 150°.

Specifically, FIG. 3a illustrates the tilted reflective grating 103 with a tilt angle in a range of 120° to 150° (e.g., 120°, 130°, or 150°), while FIG. 3b shows alternative angles in a range of 30° to 60° (e.g., 30°, 40°, or 60°). Adjusting the tilt angle of the tilted reflective grating 103 controls light reflection to facilitate optical transmission between the optical chip 800 and the optical waveguide routing layer 700. The selection of the tilt angle, spacing between tilted grooves 1031, and opening morphology of the tilted grooves 1031 may be adjusted as needed.

Optionally, the grating-based semiconductor optoelectronic packaging structure may include a first optical protection layer (not shown in the figures) covering the tilted grooves 1031 and/or a second optical protection layer (not shown in the figures) covering the optical waveguide routing layer 700. The second optical protection layer exposes portions of the optical waveguide routing layer 700 to form optical waveguide ports (not shown in the figures). The first and second optical protection layers may include a metal-based optical protection layer or an organic-inorganic composite optical protection layer.

The optical waveguide routing layer 700 may employ one of an organic polymer waveguide routing layer, a silicon-based waveguide routing layer, a lithium niobate waveguide routing layer, and a lithium borate waveguide routing layer.

As an example, the grating-based semiconductor optoelectronic packaging structure may include a filling layer 104 to fill the tilted grooves 1031. The filling layer 104 may include a transparent high-molecular-weight material, such as transparent polyimide (PI) or polybenzoxazole (PBO). The filling layer 104 fills the tilted grooves 1031 to facilitate processing.

Furthermore, second metal interconnects 900 may be formed on the exposed redistribution layer 400 and electrically connected to the redistribution layer 400 for subsequent electrical connections. The second metal interconnects 900 may be, and not limited to, metal bumps.

In summary, the present disclosure provides a grating-based semiconductor optoelectronic packaging structure and preparation method therefor. The present embodiment provides a composite functional chip including a first side and a second side. The first side of the composite functional chip is provided with an electrical metal wiring layer to combine with metal pillars and a redistribution layer (RDL) for electrical transmission. The second side of the composite functional chip is provided with a tilted reflective grating to combine with an optical waveguide wiring layer and an optical chip for optical transmission. The composite functional chip enables the integrated packaging of optical and electrical chips, achieving optoelectronic integration, reducing packaging size, lowering power consumption, improving reliability, and being suitable for high-density integrated packaging with excellent optoelectronic signal transmission.

It should be understood that the examples and embodiments described herein are for illustrative purposes only and that various modifications or changes in light thereof will be suggested to persons skilled in the art and are to be included within the purview of this application. Such alterations, modifications, and improvements are intended to be part of this disclosure and are intended to be within the scope of the disclosure.

## Claims

1. A method for fabricating a grating-based semiconductor optoelectronic packaging structure, comprising the following steps:
providing a wafer-level electrical chip comprising a circuit region at a bottom portion and a substrate region at a top portion;
forming a tilted reflective grating by patterning tilted grooves in the substrate region of the wafer-level electrical chip;
forming metal interconnects on a surface of the circuit region of the wafer-level electrical chip, wherein the metal interconnects are electrically connected to the circuit region of the wafer-level electrical chip;
dicing the wafer-level electrical chip to form a composite functional chip;
providing a support substrate having a debonding layer on one of its surfaces, and forming a redistribution layer on the debonding layer;
forming metal pillars on the redistribution layer, wherein first ends of the metal pillars are directly and electrically connected to the redistribution layer;
bonding the composite functional chip to the redistribution layer via the metal interconnects, wherein the metal interconnects are electrically connected to the redistribution layer;
forming an encapsulation layer covering the metal pillars, the composite functional chip, and the redistribution layer while exposing second ends of the metal pillars and the tilted reflective grating;
forming an optical waveguide routing layer on the encapsulation layer, wherein the optical waveguide routing layer is aligned to be at a preset position with the tilted reflective grating; and
providing an optical chip having a photosensitive region, bonding the optical chip onto the encapsulation layer, wherein the optical chip is electrically connected to the second ends of the metal pillars, and the photosensitive region is aligned to receive light from the tilted reflective grating.

2. The method of claim 1, wherein the tilted reflective grating has a tilt angle in a range of 30°to 60° or 120° to 150°.

3. The method of claim 1, further comprising:
forming a first optical protection layer covering the tilted grooves;
and/or, forming a second optical protection layer covering the optical waveguide routing layer, wherein the second optical protection layer exposes portions of the optical waveguide routing layer to form optical waveguide ports;
wherein the first optical protection layer and the second optical protection layer each comprises a metal-based optical protection layer or an organic-inorganic composite optical protection layer, wherein both are formed by a semiconductor patterning method.

4. The method of claim 1, wherein the optical waveguide routing layer is formed by a semiconductor patterning method and comprises one of an organic polymer waveguide routing layer, a silicon-based waveguide routing layer, a lithium niobate waveguide routing layer, and a lithium borate waveguide routing layer.

5. The method of claim 1, further comprising forming a filling layer to fill the tilted grooves, wherein the filling layer comprises a high-molecular-weight transparent filling layer.

6. A grating-based semiconductor optoelectronic packaging structure fabricated by the method of any one of claims 1 to 5, comprising:
a redistribution layer;
a composite functional chip, disposed on the redistribution layer, comprising a circuit region at a bottom portion and a substrate region at a top portion, wherein the substrate region comprises a tilted reflective grating comprising tilted grooves, and wherein a surface of the circuit region comprises metal interconnects electrically connected to the circuit region and the redistribution layer;
metal pillars, disposed on the redistribution layer, wherein first ends of the metal pillars are directly and electrically connected to the redistribution layer;
an encapsulation layer, wherein the encapsulation layer covers the metal pillars, the composite functional chip, and the redistribution layer while exposing second ends of the metal pillars and the tilted reflective grating;
an optical waveguide routing layer, disposed on the encapsulation layer and aligned with the tilted reflective grating; and
an optical chip, bonded onto the encapsulation layer, wherein the optical chip comprises a photosensitive region and is electrically connected to the second ends of the metal pillars, and the photosensitive region is optically aligned with the tilted reflective grating.

7. The structure of claim 6, wherein the tilted reflective grating has a tilt angle in a range of 30° to 60° or 120° to 150°.

8. The structure of claim 6, further comprising:
a first optical protection layer covering the tilted grooves;
and/or, a second optical protection layer covering the optical waveguide routing layer, wherein the second optical protection layer exposes portions of the optical waveguide routing layer to form optical waveguide ports;
wherein the first optical protection layer and the second optical protection layer each comprises a metal-based optical protection layer or an organic-inorganic composite optical protection layer.

9. The structure of claim 6, wherein the optical waveguide routing layer comprises one of an organic polymer waveguide routing layer, a silicon-based waveguide routing layer, a lithium niobate waveguide routing layer, and a lithium borate waveguide routing layer.

10. The structure of claim 6, further comprising a filling layer to fill the tilted grooves, wherein the filling layer comprises a high-molecular-weight transparent filling layer.
